# EUROPEAN PATENT APPLICATION

(11) **EP 4 657 459 A1**
(43) Date of publication of application: **03.12.2025**
(21) Application number: 23918463.3
(22) Date of filing: 21.08.2023
(51) Int. Cl.: G16Z 99/00

(54) **METHOD, PROGRAM, MEDIUM, AND DEVICE RELATING TO SIMULATION OF PARTICLES**

(30) Priority: 25.01.2023 JP 2023009562
(71) Applicant: JX Advanced Metals Corporation, Tokyo 105-8417 (JP)
(72) Inventor: SODA, Rikio, Tokyo 105-8417 (JP); YAMAMOTO, Michinori, Tokyo 105-8417 (JP)
(74) Representative: Mewburn Ellis LLP
(86) International application number: PCT/JP2023/030026
(87) International publication number: WO 2024/157503

(57) **Abstract**

The objective of the present disclosure is to provide a means of reducing a burden on users when placing particles.

In one aspect, provided is:
a program for simulating particles motion in a container, a medium, a method using the same, and a device in which the program is installed.

The program is able to command a processor of an information processing device to execute steps including:
reading three-dimensional data of the container;
reading particles data;
setting a first area including at least a portion of an interior space of the container; and
placing particles in a third area, wherein the third area is an area common to the first area and a second area, and wherein the second area corresponds to the interior space of the container at least based on the three-dimensional data.

## Description

### [Technical field]

The present disclosure relates to a method, program, medium, and device for simulating particles. In particular, the present disclosure relates to a program for simulating particles motion in a container, a method using the program, a medium storing the program, and a device in which the program is installed.

### [Technical Background]

The discrete element method (DEM) is known as a method for simulating particles motion. In this method, particles are first considered as elements such as spheres. Next, the contact and/or sliding between each element is calculated. Then, the motion of each element at each time is tracked.

When simulating particles motion in a container, it may be necessary to place the particles in the container. Patent document 1 discloses inputting a range for placing virtual particles, followed by setting the coordinate positions where the virtual particles are placed.

### [Prior Art Document]

### [Patent Document]

[Patent Document 1] Japanese Patent Publication No. 2011-081530

### [Summary of Invention]

### [Problem to be Solved]

There are several methods of placing particles in a container, for example, including a method in which a portion of the space in the container is designated as a range and the particles are placed within that range. In this case, if an extremely narrow range is designated with respect to the bottom of the container, the particles will be clustered in a part of the bottom. On the other hand, designating a range close to the entire bottom surface of the container involves precise manipulation of an input device. In other words, small deviations of designating that range may cause particles to be placed outside the container or to be placed in a position that overlaps a container wall.

Therefore, when using software to simulate particles in a container, manipulating an input device to place particles requires precision, is cumbersome for users, and requires their concentration. The objective of the present disclosure is to reduce a burden on users when placing particles.

### [Means to Solve the Problem]

In one aspect, the invention to achieve the above objective is specified as follows.

A program for simulating particles motion in a container, and a non-transitory medium storing the program, the program being able to command a processor of an information processing device to execute steps including:
reading three-dimensional data of the container;
reading particles data;
setting a first area including at least a portion of an interior space of the container; and
placing particles in a third area, wherein the third area is an area common to the first area and a second area, and wherein the second area corresponds to the interior space of the container at least based on the three-dimensional data.

In another aspect, the invention to achieve the above objective is specified as follows:
A method for simulating particles motion in a container using a program,
the method comprising the following steps, executed by commanding a processor of an information processing device:
   reading three-dimensional data of the container,
   reading particles data;
   setting a first area including at least a portion of an interior space of the container; and
   placing particles in a third area, wherein the third area is an area common to the first area and a second area, and wherein the second area corresponds to the interior space of the container at least based on the three-dimensional data.

In another aspect, an invention to achieve the above objective is a device in which the above-described program is installed and/or the non-transitory storage medium storing the program.

### [Effect of Invention]

In one aspect, the above invention includes placing particles in the third area common to the first area and the second area, which correspond to the interior space of the container at least based on three-dimensional data. This allows users to properly place particles without having to perform precise manipulation, and reduces a burden on the users.

### [Brief Description of Drawings]

[Fig. 1] An information processing device of the present disclosure in one embodiment is shown.
[Fig. 2] A system of the present disclosure in one embodiment is shown. The system may include a plurality of terminals and at least one server. The terminals and the server may be connected through a network.
[Fig. 3] A method of the present disclosure in one embodiment is shown.
[Fig. 4] A method of the present disclosure in one embodiment is shown.
[Fig. 5] An interface of the present disclosure in one embodiment is shown. The interface may include an item for receiving a three-dimensional data file (represented as a "3D data file" in Fig. 5, and the same in the following figures) of a container and an item for receiving particles data. The interface may also include an item for displaying the container in 3D format.
[Fig. 6] An interface of the present disclosure in one embodiment is shown. Although the interface is similar to the interface shown in Fig. 5, it may include items for setting properties of the container. Specifically, properties may be set to allow or disallow placement of particles into the interior of the container (filling the interior of the container with particles).
[Fig. 7] In one embodiment, a method for setting a first area is shown. After clicking on a certain point (the down arrow), the area can be designated by dragging (the diagonal down arrow). The shape of the designated area may be a rectangular cuboid.
[Fig. 8] In one embodiment, a method for setting a first area is shown. After clicking on a certain point (the first down arrow), the area can be designated by subsequently clicking on another point (the second down arrow). The shape of the designated area may be a rectangular cuboid.
[Fig. 9] In one embodiment, a method for setting a first area is shown. After clicking on a certain point (the down arrow), the area can be designated by dragging (the diagonal down arrow). The shape of the designated area may be a cylinder.
[Fig. 10] In one embodiment, a method for setting a first area is shown. After clicking on a certain point (the down arrow), the area can be designated by dragging (the diagonal down arrow). The shape of the designated area may be a polygonal column.
[Fig. 11] In one embodiment, a method for setting a second area is shown.
[Fig. 12] In one embodiment, a method for setting a third area is shown. To show the relationship between the first area, the second area, and the third area in an easy-to-understand manner, the container in the side view is shown.
[Fig. 13] In one embodiment, the state in which particles are placed after the third area has been set is shown.
[Fig. 14] The states in which particles are placed above the container, particles are dropped into the container, and particles remaining on the structure are dropped by vibration or other means are shown.
[Fig. 15] A method of the present disclosure in one embodiment is shown.
[Fig. 16] An interface of the present disclosure in one embodiment is shown. The interface may include an item for receiving a three-dimensional data file of a container, an item for receiving a three-dimensional data file of a structure, and an item for receiving particles data. The interface may also include an item for displaying the container in 3D format.
[Fig. 17] A method for setting a third area in one embodiment is shown.
[Fig. 18] A method of the present disclosure in one embodiment is shown.
[Fig. 19] A method of the present disclosure in one embodiment is shown.

### [Description of Embodiments]

Specific embodiments for carrying out the inventions are described below. The following description is intended to facilitate understanding of the inventions. That is, it is not intended to limit the scope of the inventions.

### 1. Overview

In one embodiment, the present disclosure relates to a program for simulating particles motion in a container, a medium storing the program, a device in which the program is installed, a method using the program, and a method for producing data using the program.

The technical field of application of the disclosure is not particularly limited and the disclosure can be applied to any technical field that simulates particles motion in a container. Examples of technical fields include, but are not limited to: particles motion during agitation in a container, particles motion in a fluidized bed, particles motion with a screw feeder, particles motion in a hopper, particles motion in a classifier, particles motion in a granulator, particles motion in a pneumatic conveying device, particles motion in a powder weigher, particles motion in a consolidation molding machine, particles motion in powder mixers, particles motion in tableting machine, etc.

The size of the particles is also not particularly limited, and methods and programs of the present disclosure are applicable to particles of any size. For example, the size of the particles may be milli-order, micro-order, or nano-order. Particles include discrete objects such as solids, atoms, and molecules. The type of particles is also not particularly limited, and through methods and programs of the present disclosure, motion of one type of particles can be simulated, or motion of two or more types of particles can be simulated. The shape of particles and the number of particles are also not particularly limited.

### 2. Environment for executing program

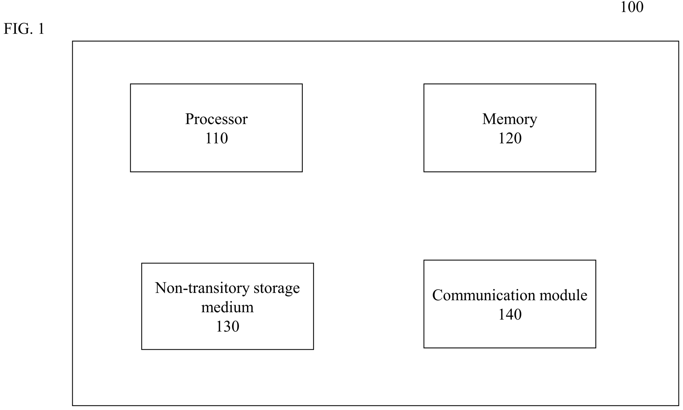

The environment for executing program and method is not particularly limited, and a typical information processing device can be used. Typically, the information processing device (100) can include a processor (110), memory (120), a non-transitory storage medium (130), and a communication module (140), as shown in Fig. 1.

For example, the information processing device (100) may include, but is not limited to: a server, a personal computer, a tablet device, a smartphone, a smart watch, smart glasses, etc.

The program is stored on a non-transitory storage medium (130, for example, HDD, SSD, etc.), loaded into memory (120, for example, RAM, etc.) as appropriate, and executed by a processor (110, for example, CPU, etc.). If necessary, the program can be connected to a network through a communication module (140) to transmit and receive information.

In one embodiment, a program may be installed in one information processing device (100) as application software, and may be executed by the information processing device (100).

In other embodiment, the number of information processing device (100) is not limited to one, and multiple information processing devices (100) may be used as needed. In that case, the functionality of the program may be distributed to multiple information processing devices (100).

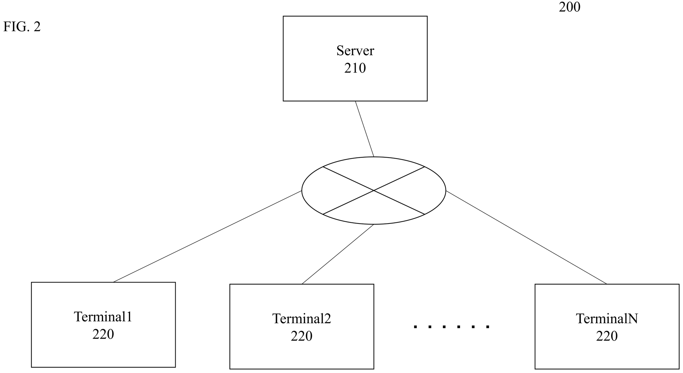

Alternatively, as shown in Fig. 2, a system (200) may be configured in which a server (210) and terminals (220) are interconnected through a network. In the system (200), the terminals (220) may receive input from users and may transmit at least a portion of the received input to the server (210). The server (210) may receive the input information transmitted from the terminals (220), may process the information, and may transmit a portion of output to the terminals (220). The terminals (220) may then receive the output information transmitted from the server (210) and may display it at the terminals (220).

In another aspect, therefore, the present disclosure also relates to an information processing device including the program of the present disclosure, and a system including the information processing device. In yet another aspect, the present disclosure relates to a terminal and/or a server that constitutes a system of the present disclosure. The internal configuration of the terminals and the server may be same as or similar to that of the information processing device shown in Fig. 1. In another aspect, the present disclosure relates to a storage medium (e. g., a non-transitory storage medium, for example, a computer readable non-transitory storage medium, such as HDD, SSD, flash memory, optical disk, etc.) storing a program.

### 3. Overview of program steps

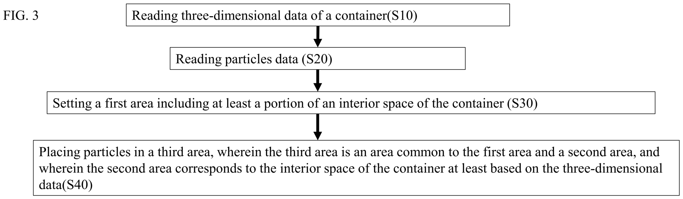

In one embodiment, the program of the present disclosure executes steps including at least the following (Fig. 3):
reading three-dimensional data of a container(S10);
reading particles data (S20);
setting a first area including at least a portion of an interior space of the container (S30); and
placing particles in a third area, wherein the third area is an area common to the first area and a second area, and wherein the second area corresponds to the interior space of the container at least based on the three-dimensional data (S40).

Specific examples of programs including execution of the above series of steps are described below as each embodiment.

### 4. First embodiment

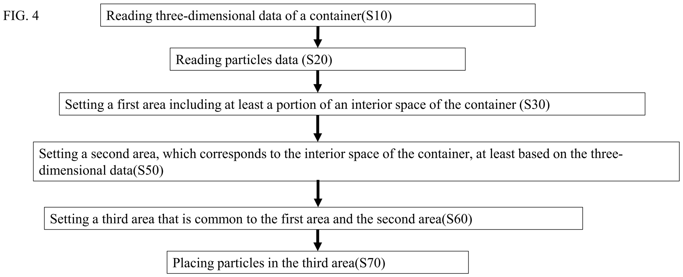

In one embodiment, a program of the present disclosure executes steps including at least the following (Fig. 4):
reading three-dimensional data of a container (S10); reading particles data(S20);
setting a first area including at least a portion of an interior space of the container(S30);
setting a second area corresponding to the interior space of the container at least based on the three-dimensional data (S50);
setting a third area common to the first area and the second area (S60); and
placing particles in the third area(S70).

Each of the above steps is described in detail below.

### 4-1. Reading three-dimensional data of a container

The format of the three-dimensional data of the container is not particularly limited. Typically, the format of the three-dimensional data of the container may be a CAD file. Alternatively, the format of the three-dimensional data of the container may be in the form of point cloud data acquired by a 3D scanner. For example, the file of the three-dimensional data of the container may be a file with the following extensions: ". model", ". CATPart", ". CATProdet", ". sldprt", ". sldasm", ". prt", ". asm", ". ipt", ". iam", ". x_t", ". x_b", ". xmt_txt", ". sat", ". sab", ". jt", ". dxf", ". dwg", ". dwf", ". igs", ". iges", ". stp", ". step", ". stl", ". obj", ". amf", ".3mf", ". wrl", ". vda", ". skp", ".3dm", ". rvt", ". qif", ". ply", ". anf", ". pkg", ". idf", ". idb", ". emn", ". prt", " sat", ". asat", ". sat", ". asat", ".3dxml" ". rsdoc", ". scdoc".

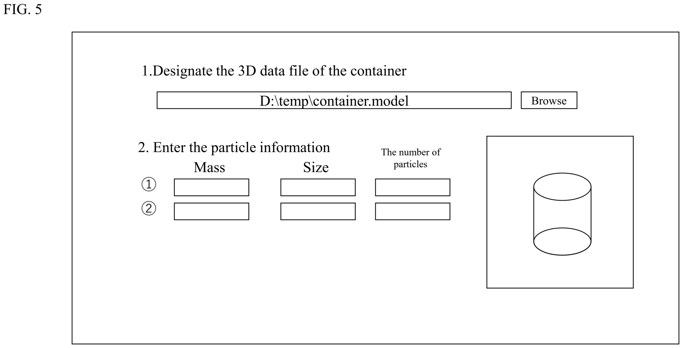

The step of reading three-dimensional data of a container may be initiated by a user operation. Typically, the step of reading three-dimensional data of a container may include uploading a designated file to an information processing device in response to the user operation. The device may also provide a user interface for uploading. For example, as shown in Fig. 5, an interface may be provided for designating a file stored locally or stored in cloud. Furthermore, after reading the three-dimensional data of the container, an object representing the shape of the container may be displayed on the user interface.

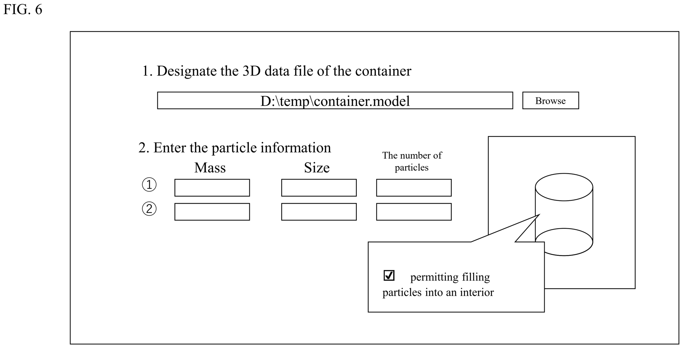

Before, during, or after reading the three-dimensional data of the container, the information processing device may assign a property to the data indicating whether filling particles into the interior is permitted or prohibited. As shown in Fig. 6, the process of assigning such a property may be executed in response to user operation (for example, by clicking a check box), or alternatively, it may be executed automatically by the information processing device executing a predetermined process. Typically, when executed automatically, the property is assigned to allow particles to be filled into the interior of the container.

### 4-2. Reading particles data

In addition to the reading three-dimensional data of a container, the program of the information processing device executes reading particles data. Both steps can be executed in any order. That is, the program of the information processing device may execute reading three-dimensional data of a container followed by reading particles data. Alternatively, the program of the information processing device may execute reading particles data before reading three-dimensional data of the container. Alternatively, the program of the information processing device may execute reading three-dimensional data of a container and reading particles data in parallel.

Typically, the step of reading particles data may include receiving, by the information processing device, the particles data in response to an input operation from a user. The device may also provide items for receiving on a user interface. For example, as shown in Fig. 5, an item may be provided on the interface for inputting data regarding various properties about the particles. When multiple types of particles are simulated, items may be provided on the interface for inputting data regarding properties for each type of particles.

Reading particles data may also include uploading, via the information processing device, a designated file containing the particles data in response to a user operation. In this case, an item similar to the item shown in Fig. 5 for uploading a file of three-dimensional data of a container may be provided on the interface.

The particles data may include, without limitation, one or more of the following: particle size (for example, diameter), shape, Poisson's ratio, Young's modulus, friction coefficient, repulsion coefficient, contact angle, substance name, mass per particle, volume per particle, density, and the number of all the particles to be placed in the third area described below, mass, and volume. Of these, the following three pieces of information (1)-(3) are particularly important in the placement of particles.
(1) Either of the size or mass per particle
(2) The shape of the particles, and
(3) Either of the total number, mass, and volume of particles to be placed in the third area

### 4-3. Setting a first area

Setting a first area may be executed independently of the above reading particles data. That is, setting a first area may be executed before, after, or in parallel with reading particles data.

Setting a first area is executed after reading three-dimensional data of a container. The reason is that the first area contains at least a portion of the interior space of the container and thus the three-dimensional data of the container must be read in advance.

Typically, setting a first area is executed after reading three-dimensional data of a container and after displaying the three-dimensional data of the container.

The step of setting a first area is typically executed in response to a user operation. The user operation includes an operation to designate the first area. For example, the user operation may include an operation to designate at least two points in three-dimensional spatial coordinates. The method of designating is not particularly limited and may include clicking on at least two points, or alternatively, it may include clicking on and starting drag at one point and then ending the drag at another point.

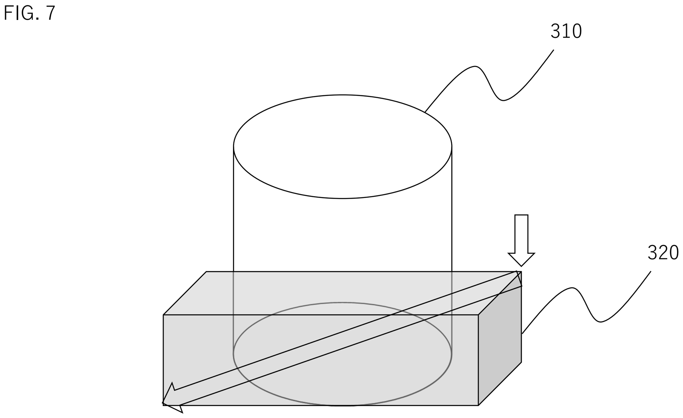

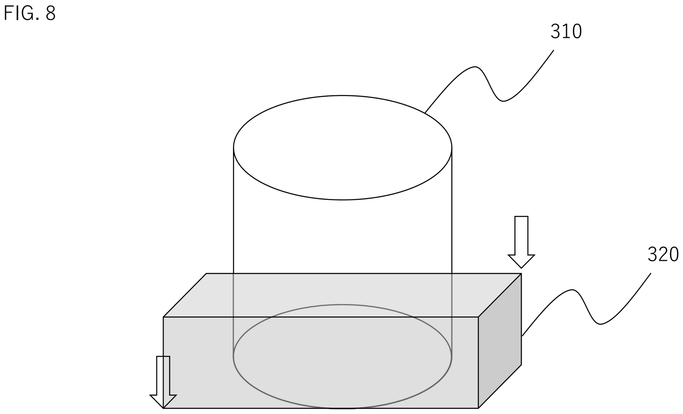

For example, a mouse or trackball may be used to click on one point and then drag to another point (see the down arrow and the diagonal down arrow in Fig. 7). In another example, a touch panel or touch pad may be used to tap at one point and then drag to another point. In yet another example, a mouse or trackball may be used to click on one point and then click again at another point (see the two down arrows in Fig. 8). In yet another example, a touch screen or touch pad may be used to tap at one point and then tap again at another point.

Although the above examples are examples of using a mouse or trackball, it is also possible to set the first area by another method. For example, a user may input certain values for two coordinate points in three-dimensional space on an interface.

If an area set by a user's operation does not include the interior space of the container at all, the information processing device may display an error indicating this on the interface.

In other embodiments, setting a first area may be executed automatically by the information processing device based on three-dimensional data of the container, rather than by a user operation. As an example, the information processing device may set the first area to include all the interior space of the container based on the three-dimensional data of the container. As another example, the information processing device may automatically input two coordinate points on the interface so that the first area includes all of the interior space of the container based on the three-dimensional data of the container, and a user may modify the two coordinate points as necessary.

In response to the above user operation or after the above execution of the information processing device, the information processing device may set the first area represented by a predetermined three-dimensional shape. The three-dimensional shape is not particularly limited and includes cylindrical, polygonal-prism, rectangular-cuboid, cubic, spherical, and the like. The 3D shape is preferably a rectangular cuboid (see Fig. 7 and Fig. 8).

In the case of a rectangular cuboid, the two points designated by the above operations may correspond to the two vertices that are farthest from each other in the rectangular cuboid.

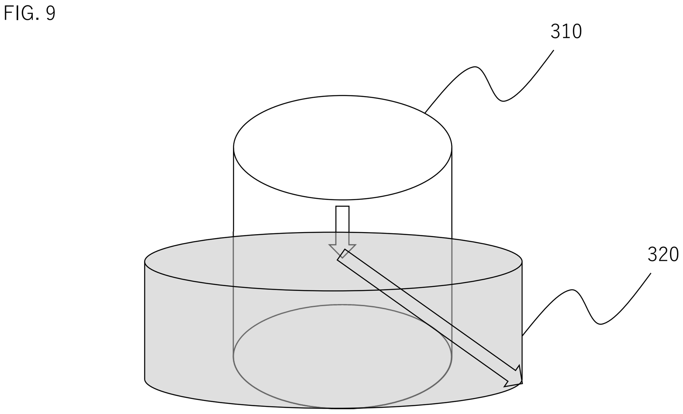

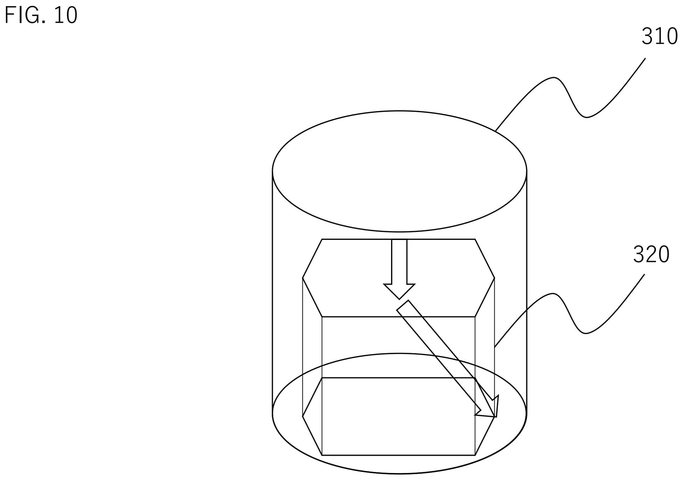

Alternatively, in the case of a cylindrical shape, the two points designated by the above operations may correspond to the center position of the top and one point on the circumference of the bottom in a cylindrical shape (see Fig. 9), or alternatively, may correspond to the center position of the bottom and one point on the circumference of the top. Alternatively, in the case of a polygonal prismatic shape, the two points designated by the above operations may correspond to the center location of the top surface and one of the multiple vertices of the bottom surface (see Fig. 10), or alternatively may correspond to the center location of the bottom surface and one of the multiple vertices of the top surface.

The first area represented by the three-dimensional shape is displayed on a user interface in response to a user operation. For example, the first area represented by the three-dimensional shape may be displayed such that it overlays on the container represented by the three-dimensional shape (Figures 7, 8, 9, 10).

The information of the first area that has been set is stored in the information processing device (for example, memory (120) provided by the information processing device (100)).

### 4-4. Setting a second area

Setting a second area is executed after reading three-dimensional data of a container. However, setting a second area may be executed before, after, or in parallel with reading particles data and setting a first area.

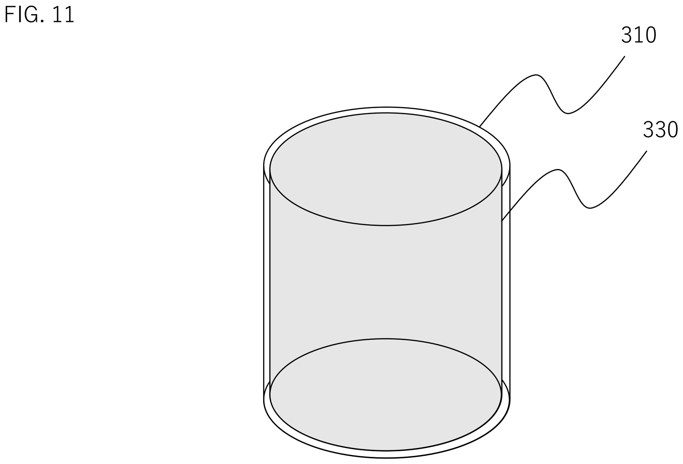

After reading the three-dimensional data of the container, the information processing device determines an area corresponding to the interior space at least based on the data, and sets the data as the second area (Fig. 11). The method of determining the area corresponding to the interior space is not particularly limited and can be determined by any method known in the art. An example of the process of setting the second area using Fig. 11 is described below. The information processing device places a cylindrical container (310) on a three-dimensional space based on three-dimensional data of the container. The information processing device calculates the radius of a particle based on the diameter of the particle included in the particles data. The information processing device sets, as the second area (330), a cylindrical area whose circumference size is smaller than the size of the container (310) by that radius. This allows avoiding a situation where particles come into contact with the walls (inner walls) of the container (310) when the particles are placed in a third area, which will be described later.

Thus, setting a second area is preferably executed automatically after reading three-dimensional data of a container, rather than in response to a user operation.

The second area may or may not be displayed in a user interface.

The information of the second area that has been set is stored in the information processing device (for example, memory (120) provided by the information processing device (100)).

### 4-5. Setting a third area

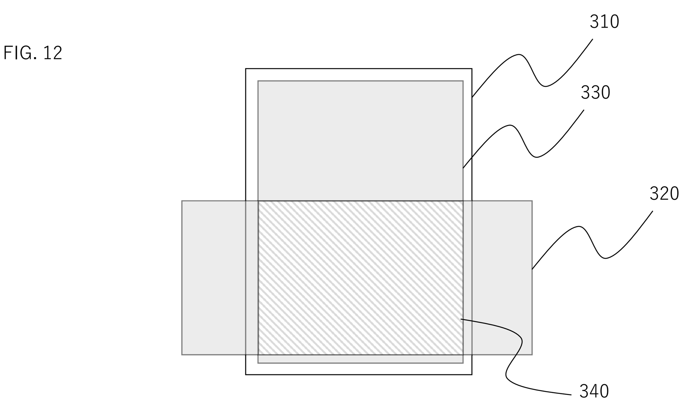

After setting a first area and setting a second area, setting a third area is executed. For example, as shown in Fig. 12, the information processing device reads the first area (320) and the second area (330) and extracts the area (340) common to both areas. The extracted area is then set as the third area. The information of the third area that has been set is stored in the information processing device (for example, memory (120) provided by the information processing device (100)).

The third area that has been set is preferably displayed on a user interface. More preferably, the first area displayed in the form of an overlay on the container represented by the three-dimensional shape may be erased, and then the third area may be overlaid on the container represented by the three-dimensional shape.

### 4-6. Placing particles

After reading particle data and after setting a third area, placing particles in the third area is executed. The information processing device places the particles so that they exist within the third area that has been set (For example, the particles are placed virtually in a virtual space for simulation. For example, it may designate location information where the particles exist in the virtual space for simulation). The method of placing particles is not particularly limited. Typically, at least based on the particles data, the information processing device can place the particles in the third area. For example, at least based on the shape of the particles, the number of the particles, and the size of the particles, the information processing device can place the particles in the third area.

When placing the particles, the particles can be placed in the third area using a stacking method from below. For example, when stacking, the particles may be stacked based on either a square array, a hexagonal close-packed array, or a random array.

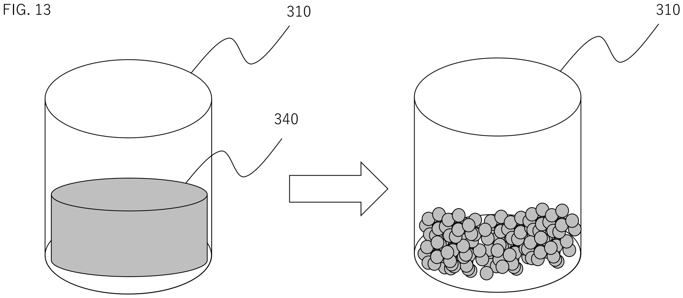

In an interface, the third area is displayed, in advance, and then a confirmation message such as "Do you want to place the particles?" may be displayed. After a user operation indicating that placing the particles is acceptable, the third area may be erased once and the particles may then be displayed (Fig. 13).

If the particle size is too large and/or the number of particles is too large, it may not be possible to place all the particles in the third area. In such a case, further particles may be placed on or above the third area. Alternatively, the information processing device may output a message through a user interface. For example, the message may be an error message that says, "The third area is too small to place all particles".

By executing the above series of steps, it is possible to place particles in a container without requiring precise manipulation from users, which would otherwise demand concentration. This is because three steps of setting a first area, setting a second area, and setting a third area enable users to set an area for placing particles close to the wall surface in the container.

### 5. Second embodiment

In the first embodiment, no structures were present in the interior space of the container. However, various structures may be placed in the interior space of the container where the particles are placed.

The term "structure" as used herein means a component attached to a container in such a way that at least a portion of the component is present in the interior space of the container and means that the component is independent of the container. For example, a structure may be a component that is removable from the container. For example, a structure may be a component that can move independently of the container. The size, shape, etc. of the structure is not particularly limited and may be any size, shape, etc. Though not limited, examples of structures include screw conveyer, propellers, grinding blades, container lids, removable baffles, etc. For example, parts that are integrated with the container (e. g., baffles that are integrated with the container) can be incorporated into the three-dimensional data of the container.

When setting up an area where particles are to be placed, it is necessary to place them in such a way that they do not overlap with the structures mentioned above.

In a method where an area designated by a user operation is set as an area where particles are to be placed, it is difficult to set the area, by an input device such as a mouse, touch pad, or other, so that it does not include structures in the container.

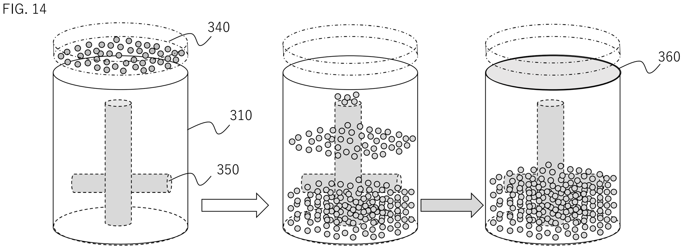

As an alternative approach, there is a method for placing particles as shown in Fig. 14. Specifically, the method as shown in Fig. 14 includes the following steps;
reading three-dimensional data of a container (310), including information on a structure (350);
setting an area (340), above the container, for placing particles;
placing particles in the set area (340);
applying gravity to the particles to cause them to drop (more preferably, applying vibration to the structure (350) or the like to cause the particles that have been dropped on top of the structure to further drop from top of the structure (350)); and
after dropping, placing a lid (360) on the top of the container.

This method makes it possible to place the particles in such a way that they do not overlap with the structure.

However, there are several problems with this method. The first problem is that particles may fall outside the container when dropping via gravity due to a small deviation in designating a range. The second problem is that particles may remain on top of the structure when they drop via gravity. And if particles remain, it may not be possible to put a lid on the container. The structure (350) could be vibrated separately to drop the particles from the top of the structure (350), but this would add extra work.

The method in the second embodiment of the present disclosure can solve these problems.

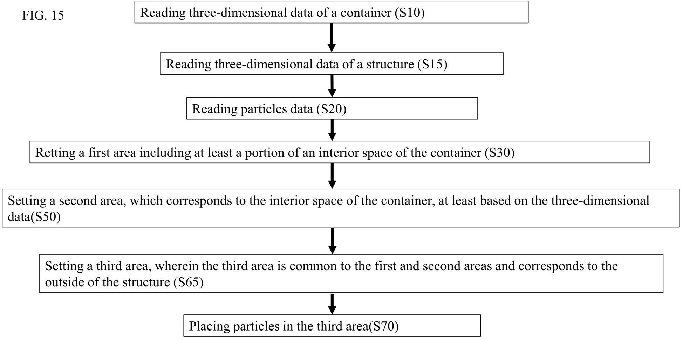

Specifically, the method in the second embodiment can include each of the steps as shown in Fig. 15. The steps as shown in Fig. 15 include the same steps as those of the method of the first embodiment mentioned above. However, as a difference, it further includes the step of reading three-dimensional data of a structure. In addition, the third area is set such that a set area is common to the first and second areas and corresponds to the outside of the structure. The steps that differ from those of the first embodiment are described in detail below.

### 5-1. Reading three-dimensional data of a structure disposed in the interior space of the container

The three-dimensional data of the structure is not particularly limited. Typically, similar to the three-dimensional data of the container, the three-dimensional data of the structure may be a CAD file, a file of point cloud data acquired by a 3D scanner, etc., and files with the above extensions may be read.

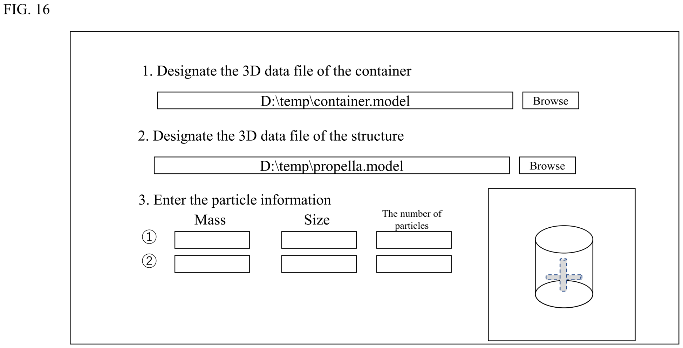

For example, an interface for reading the three-dimensional data of the structure may include an item similar to the item, as shown in Fig. 5, for uploading the three-dimensional data file of the container (Fig. 16).

As with the three-dimensional data of the container, an information processing device may, before, during, or after reading the three-dimensional data of the structure, assign a property to the data indicating whether filling particles into the interior is permitted or prohibited. The process of assigning such a property may be executed in response to user operation, or alternatively, it may be executed automatically by the information processing device executing a predetermined process.

After reading the three-dimensional data of the structure, both the container and the structure may be displayed together on an interface. The position of the structure may be adjusted to any desired position by user manipulation (for example, by dragging an object of the structure with the mouse, etc.). Alternatively, if the three-dimensional data of the structure includes information on the position of three-dimensional spatial coordinates in advance, the position of the structure can be adjusted to any desired position based on this information.

The number of structures is not limited. Therefore, depending on the number of structures, reading the three-dimensional data of the structures may be repeated multiple times.

### 5-2. Setting a third area

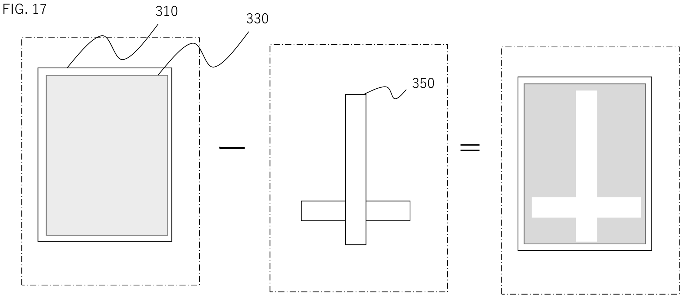

In the above first embodiment, the second area corresponds to the interior space of the container based on the three-dimensional data. In the second embodiment, the second area can be set further based on the existence of a structure. Although specific processing and calculation methods are not limited, for example, as shown in Fig. 17, the interior space area of the container may first be determined based on the three-dimensional data of the container, and then, based on the three-dimensional data of the structure, the second area may be set by subtracting a portion corresponding to the structure from the interior space area of the container.

If the third area is set in the same manner as in the first embodiment above using this second area, an area in which particles are to be placed is set to an area corresponding to the interior space of the container and corresponding to the exterior space of the structure.

Of course, it is also possible to set the third area in a method other than the above. For example, until reaching the step of "setting a third area that is common to the first area and the second area" as shown in Fig. 4, it may be processed in a manner similar to those in the first embodiment, and then the third area may be reset by subtracting a portion corresponding to the structure. Alternatively, an area common between the second area and an area obtained by subtracting a portion corresponding to the structure from the first area may be set as the third area for placing particles.

Whichever way it is executed, the third area is ultimately set to an area corresponding to the interior space of the container and corresponding to the exterior space of the structure.

When the third area is set in this manner, particles can be placed such that they do not overlap the structure.

### 6. Third embodiment

In the first embodiment, the second area and the third area are set by the information processing device. In the third embodiment of the present disclosure, particles are placed substantially in the third area without setting the second area and the third area.

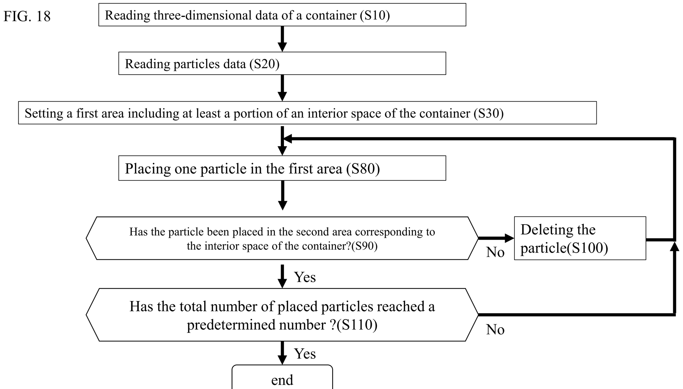

Specifically, the method in the third embodiment can include each of the steps shown in Fig. 18. The steps shown in Fig. 18 are partially common to those of the method of the first embodiment mentioned above. The steps that differ from those of the first embodiment are described in detail below.

### 6-1. Placing particles

After setting the first area, placing one particle in the first area is executed. When placing, any coordinate point in the first area may be selected. When selecting, if there is a particle that has already been placed, the coordinate point may be selected after determining whether it does not overlap with that particle.

### 6-2. Determining whether particles have been placed in the second area

Determining whether particles have been placed or not in the second area, which corresponds to the interior space of the container, is executed. For example, the information processing device can use three-dimensional spatial coordinates of the placed particles and three-dimensional data of the container to determine the intersection of a plane (for example, a triangle) and a line segment. For example, by converting the three-dimensional data of the container into data expressed with polygons, every part of the container can be represented by a combination of polygonal faces. Then, it is determined whether the faces intersect with line segments extending in any direction from the three-dimensional spatial coordinates of the placed particles (for example, the coordinates of the center position of the particles). If the number of intersections is odd, it can be determined that the particle is inside the container. If the number of intersections is even, it can be determined that the particle is outside the container.

An algorithm for determining the intersection of a plane (for example, a triangle) with a line segment is not particularly limited, and any algorithm used in the field can be employed. For example, such a step may be executed based on Tomas Moller's algorithm for determining whether an object is inside or outside (for example, see: Tomas Moller and Ben Trumbore. Journal of Graphics Tools, 2(1):21-28, 1997).

If it is determined that the particle has not been placed in the second area (the interior space of the container), the information processing device executes deleting the particle placed in the first area and placing the particle in the first area again.

If it is determined that the particle has been placed in the second area, the information processing device proceeds to the next step without deleting the particle.

At this time, the information processing device may further execute determining whether the particle placed in the second area is in contact with the wall of the container based on the size of the particle and the three-dimensional data of the container. If it is determined that the particle is in contact with the walls of the container, the information processing device executes deleting the particle and placing the particle in the first area again.

The particles placed in this manner will be located in an area common to the first and second areas (i. e., the third area).

### 6-3. Determining whether the total number of placed particles has reached a predetermined number

When it is determined that the particles have been placed in the second area, the information processing device executes determining whether the total number of the placed particles has reached a predetermined number. The predetermined number may be; the number of the particles to be placed in the third area included in particle data; the number of the particles calculated from the mass of the particles included in the particle data and the mass of the particles placed in the third area; or the number of the particles calculated from the volume of the particles included in the particle data and the volume of the particles placed in the third area.

If the information processing device determines that the total number of the placed particles has reached the predetermined number, it terminates a series of process of placing particles; otherwise, it executes placing the particles in the first area again.

In the third embodiment, the information processing device does not execute setting the second area corresponding to the interior space of the container and setting the third area common to the first area and the second area.

Therefore, the process executed in the third embodiment can reduce the calculation time required for the process of placing particles compared to the process executed in the first embodiment.

Although the particles are placed one at a time in the first area in the above, multiple particles may be placed simultaneously.

The process executed in the second embodiment and the process executed in the third embodiment can be combined.

As an example, after or before determining whether the particles have been placed in the second area, the information processing device executes determining whether the particles are located outside of a structure. For example, this process may be based on determining the intersection of a plane and a line segment using the three-dimensional spatial coordinates of the placed particle and the three-dimensional data of the structure. If the number of intersections is odd, it can be determined that the particle is inside the structure. If the number of intersections is even, it can be determined that the particle is outside the structure. If it is determined that the particle is inside the structure, the placed particle can be deleted in a manner as similar to S100 of Fig. 18. Similarly to the above, an algorithm for determining the intersection of a plane (for example, a triangle) with a line segment is not particularly limited, and any algorithm used in the field can be employed. As an example, it can be executed by an information processing device based on Tomas Moller's algorithm for determining whether an object is inside or outside.

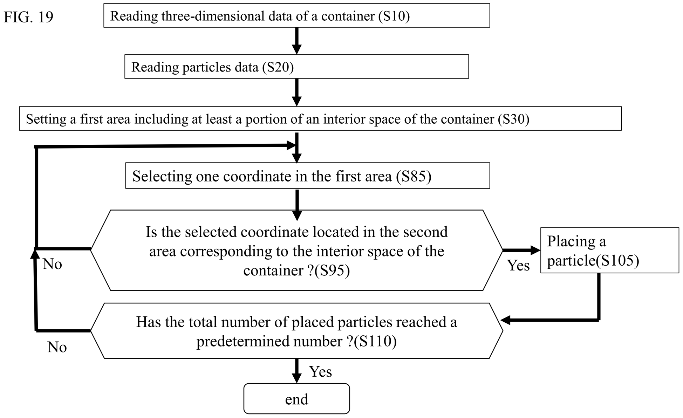

The method shown in the third embodiment can be modified in several ways. For example, instead of the method shown in Fig. 18, the method shown in Fig. 19 may be executed. In the method shown in Fig. 18, once the particle is placed, it is determined whether the placed particles are placed in the second area corresponding to the interior space of the container. If no, the particles are then deleted.

In the method shown in Fig. 19, coordinates are selected and it is then determined whether the coordinates are located in the second area corresponding to the interior space of the container. This determination may be made in a manner similar to the method shown in Fig. 18 which uses three-dimensional spatial coordinates of the placed particles and the three-dimensional data of the container to determine the intersection of a plane (for example, a triangle) with a line segment.

If the result of the determination is yes, the particle is placed; and if no, the particle is not placed and the process returns to the step of selecting one coordinate in the first area to select another coordinate.

The above method allows for placing particles in a manner similar to that shown in Fig. 18.

### 7. Forth embodiment

In addition to the process executed according to at least one of the first embodiment, the second embodiment, and the third embodiment, the fourth embodiment may further include, in the container according to gravity, repositioning particles placed in the third area. Specifically, after applying gravity to the particles, the process may be executed to simulate particles motion when they drop according to gravity. The specific processing method for simulating is not limited, but typically, it may be simulated according to the Discrete Element Method or the Distinct Element Method.

This allows for particles to be placed in a state closer to reality. Of course, particles may be stacked based on either a square array, a hexagonal close-packed array, or a random array, but this may result in particles being placed in an unnaturally organized manner, unnaturally with no gaps, or unnaturally with gaps present. Such unnaturalness can be eliminated by processing the particles to drop according to gravity.

In addition, when the second embodiment and the fourth embodiment are combined, or when the third embodiment (the third embodiment with a structure) and the fourth embodiment are combined, there are advantages over the method of placing shown in Fig. 14.

In particular, in the method of placing shown in Fig. 14, as stated above, particles may drop outside the container. For the purpose of avoiding this, an area can be set narrower. However, if the particles are placed in a narrower space, it will take more time to calculate the process to make them drop.

However, when the second embodiment and the third embodiment are combined, or when the third embodiment (the third embodiment with a structure) and the fourth embodiment are combined, it is possible to set an area where the particles are placed without users having to consider the possibility of the particles dropping outside the container. It is then possible to extend an area where the particles are placed to near the walls of the container. Thus, the time taken to execute the process of dropping the particles can be minimized.

### 8. Later process

After executing each of the steps shown in one or more of the first embodiment, the second embodiment, the third embodiment, and the fourth embodiment above, a program can further include applying force to a container or a structure to move these objects and simulate particles motion. The specific processing method for simulating is not particularly limited, but typically, it may be simulated according to the Discrete Element Method or the Distinct Element Method.

After executing the above simulating, the program may create data defining particles motion. Such data can include information about time and position in three-dimensional spatial coordinates for each particle. A desired application software can then read the above data and reproduce the particles motion on a user interface.

In one embodiment, therefore, the present disclosure relates to a method for producing data relating simulation of particles motion in a container.

The detailed embodiments of the present invention have been described. The above embodiments are merely an example, and the present invention is not limited to the above embodiments. For example, a technical feature disclosed in one of the above embodiments may be applied to another embodiment. Furthermore, unless indicated specifically, regarding a particular method, some steps may be switched with the order of some other steps, and further steps may be inserted between certain two steps. The scope of the present invention is defined by the appended claim.

### 9. Appendix

In one aspect, the present disclosure includes the following inventions.

### (Invention 1)

A program for simulating particles motion in a container, the program being able to command a processor of an information processing device to cause the device to execute steps including:
reading three-dimensional data of the container;
reading particle data;
setting a first area including at least a portion of an interior space of the container; and
placing particles in a third area, wherein the third area is an area common to the first area and a second area, and wherein the second area corresponds to the interior space of the container at least based on the three-dimensional data.

### (Invention 2)

The program of Invention 1,
the program being able to further execute reading three-dimensional data of a structure at least partially disposed in the interior space of the container,
wherein the third area is a space corresponding to outside of the structure.

### (Invention 3)

The program of Invention 1 or 2, placing particles comprises:
selecting an arbitrary coordinate point within the first area;
determining whether the coordinate point or corresponding particle location is within the second area;
if it is determined that the coordinate point or the corresponding particle location is not within the second area, setting so that no particle is present at the coordinate point; and
if it is determined that the coordinate point or the corresponding particle location is within the second area, then setting so that the particle is present at the coordinate point.

### (Invention 4)

The program of any one of Inventions 1-3, wherein the step of setting the first area includes setting the first area at least based on at least two three-dimensional spatial coordinate points.

### (Invention 5)

The program of any one of Inventions 1-4, being able to further execute repositioning, into the container in accordance with gravity, the particles that have been placed.

### (Invention 6)

The program of Invention 5, wherein repositioning includes repositioning in accordance with a discrete element method.

### (Invention 7)

The program of any one of Inventions 1-6, being able to execute further simulating particles motion

### (Invention 8)

A method including executing the program of any one of Inventions 1-7 using an information processing device.

### (Invention 9)

A method for producing data relating simulation of particles motion in a container, the method comprising executing, using an information processing device, the program of any one of Inventions 1-7.

In another aspect, the present disclosure includes the following inventions.

### (Invention 1)

A method for simulating particles motion in a container using a program,
the method comprising the following steps, executed by commanding a processor of an information processing device:
reading three-dimensional data of the container;
reading particle data;
setting a first area including at least a portion of an interior space of the container; and
placing particles in a third area, wherein the third area is an area common to the first area and a second area, and wherein the second area corresponds to the interior space of the container at least based on the three-dimensional data.

### (Invention 2)

The method of Invention 1,
further comprising reading three-dimensional data of a structure at least partially disposed in the interior space of the container,
wherein the third area is a space corresponding to outside of the structure.

### (Invention 3)

The method of Invention 1 or 2, wherein placing particles comprises:
selecting an arbitrary coordinate point within the first area;
determining whether the coordinate point or corresponding particle location is within the second area;
if it is determined that the coordinate point or the corresponding particle location is not within the second area, setting so that no particle is present at the coordinate point; and
if it is determined that the coordinate point or the corresponding particle location is within the second area, then setting so that the particle is present at the coordinate point.

### (Invention 4)

The method of any one of Inventions 1-3, wherein the method of setting the first area includes setting the first area at least based on at least two three-dimensional spatial coordinate points.

### (Invention 5)

The method of any one of Inventions 1-4, being able to further execute repositioning, into the container in accordance with gravity, the particles that have been placed.

### (Invention 6)

The method of Invention 5, wherein repositioning includes repositioning in accordance with a discrete element method.

### (Invention 7)

The method of any one of Inventions 1-6, further comprising simulating particles motion.

### (Invention 8)

A non-transitory storage medium storing a program for simulating particles motion in a container,
the program being configured to command a processor of an information processing device to execute the following:
reading three-dimensional data of the container;
reading particles data;
setting a first area including at least a portion of an interior space of the container; and;
placing particles in a third area, wherein the third area is an area common to the first area and a second area, and wherein the second area corresponds to the interior space of the container at least based on the three-dimensional data.

### (Invention 9)

A device comprising the non-transitory storage medium of Invention 8.

### [Explanation of references]

- 100: Information processing device
- 110: Processor
- 120: Memory
- 130: Non-transitory storage medium
- 140: Communication module
- 200: System
- 210: Server
- 220: Terminal
- 310: Container
- 320: First area
- 330: Second area
- 340: Third area
- 350: Structure
- 360: Lid

## Claims

1. A method for simulating particles motion in a container using a program,
the method comprising the following steps, executed by commanding a processor of an information processing device:
reading three-dimensional data of the container;
reading particles data;
setting a first area including at least a portion of an interior space of the container; and
placing particles in a third area, wherein the third area is an area common to the first area and a second area, and wherein the second area corresponds to the interior space of the container at least based on the three-dimensional data.

2. The method of claim 1,
further comprising reading three-dimensional data of a structure at least partially disposed in the interior space of the container,
wherein the third area is a space corresponding to an outside of the structure.

3. The method of claim 1, wherein placing particles comprises:
selecting an arbitrary coordinate point within the first area;
determining whether the coordinate point or corresponding particle location is within the second area;
if it is determined that the coordinate point or the corresponding particle location is not within the second area, setting so that no particle is present at the coordinate point; and
if it is determined that the coordinate point or the corresponding particle location is within the second area, then setting so that the particle is present at the coordinate point.

4. The method of claim 1, wherein the method of setting the first area includes setting the first area at least based on at least two three-dimensional spatial coordinate points.

5. The method of claim 1, being capable of further executing repositioning, into the container in accordance with gravity, the particles that have been placed.

6. The method of claim 5, wherein repositioning includes repositioning in accordance with a discrete element method.

7. The method of claim 1, further comprising simulating particles motion.

8. A non-transitory storage medium storing a program for simulating particles motion in a container,
the program being configured to command a processor of an information processing device to execute the following:
reading three-dimensional data of the container;
reading particles data;
setting a first area including at least a portion of an interior space of the container; and;
placing particles in a third area, wherein the third area is an area common to the first area and a second area, and wherein the second area corresponds to the interior space of the container at least based on the three-dimensional data.

9. A device comprising the non-transitory storage medium of claim 8.
